## Europäisches Patentamt

## European Patent Office

## Office européen des brevets

(19)

(11) Numéro de publication: **0 245 154 B1**

# FASCICULE DE BREVET EUROPEEN

(12)

(45) Date de publication du fascicule du brevet: 26.09.90

(51) Int. Cl.⁵: **G01N 24/08**

(21) Numéro de dépôt: 87400958.2

(22) Date de dépôt: 24.04.87

(54) **Procédé de calibration de l'amplitude de l'excitation radiofréquence d'un appareil d'imagerie par résonance magnétique nucléaire.**

(30) Priorité: 06.05.86 FR 8606547

(43) Date de publication de la demande:
11.11.87 Bulletin 87/46

(45) Mention de la délivrance du brevet:
26.09.90 Bulletin 90/39

(84) Etats contractants désignés:
DE GB NL

(73) Titulaire: GENERAL ELECTRIC CGR S.A., 100, rue
Camille-Desmoulins, F-92130 Issy les Moulineaux(FR)

(72) Inventeur: LeRoux, Patrick, THOMSON-CSF
SCPI 19, avenue de Messine, F-75008 Paris(FR)
Inventeur: Marilier, Alain, THOMSON-CSF
SCPI 19, avenue de Messine, F-75008 Paris(FR)

(74) Mandataire: Schmit, Christian Norbert Marie et al,
Cabinet Ballot-Schmit 7, rue Le Sueur,
F-75116 Paris(FR)

(56) Documents cités:
EP-A- 0 109 238
EP-A- 0 152 879
EP-A- 0 238 139
US-A- 4 486 709

## Description

La présente invention a pour objet un procédé de calibration de l'amplitude de l'excitation radiofréquence d'un appareil d'imagerie par résonance magnétique nucléaire (RMN). Elle trouve plus particulièrement son application dans le domaine médical où de tels appareils sont utilisés à des fins de diagnostic notamment pour la détection des cancers. L'invention peut néanmoins trouver son utilisation dans d'autres domaines, notamment dans le domaine scientifique où des appareils de conception semblable peuvent être mis en oeuvre.

Un appareil de RMN comporte essentiellement un aimant pour produire un champ magnétique, dit orientateur, continu homogène et intense ($B_0$) dans un volume d'intérêt. Un corps à examiner est placé dans ce volume. Là il y est soumis en outre à une excitation radiofréquence de courte durée. Dès que l'excitation cesse, les moments magnétiques des particules du corps, qui ont été basculés sous l'effet de cette excitation, tendent à se réaligner avec le champ orientateur. En se réalignant ils restituent l'énergie prélevée pendant l'excitation sous la forme d'un signal électromagnétique que l'on capte. Le traitement de ce signal renseigne sur la nature intime du corps. Dans les procédés mettant en oeuvre des phases d'imagerie, les machines RMN sont en outre pourvues de bobines, dites de gradient, succeptibles de produire des suppléments de champ orientateur dont la distribution varie selon les coordonnées des points d'application. Des gradients de champ appliqués pendant la phase d'excitation et/ou avant, pendant, la réception du signal RMN permettent alors de coder l'espace. Par un filtrage approprié on peut extraire du signal capté des informations relatives à la nature du corps dans certaines coupes : on peut faire des images de ces coupes.

La qualité du signal reçu après l'excitation dépend essentiellement de l'efficacité de cette excitation. Schématiquement les moments magnétiques des particules sont basculés, dans le meilleur des cas, de 90 ° par rapport à l'orientation du champ orientateur. Ils retournent s'aligner avec cette orientation en précessant. Les moyens de détection du signal de précession comportent, dans leur principe, une bobine dont le plan des spires est parallèle à l'orientation du champ. Si l'excitation est trop faible, le basculement est inférieur à 90°. Si au contraire elle est trop forte le basculement est supérieur à 90°. Dans ces deux cas le signal mesuré aux bornes de la bobine est affaibli. Le rapport signal à bruit est alors moins bon. Si on appelle θ l'angle de basculement on peut même affirmer que l'amplitude du signal détecté est proportionnelle à sin θ. D'où l'intérêt à rendre θ égal à 90°.

Or tous les corps ne présentent pas une même impédance éléctromagnétique vis à vis de l'excitation. Intuitivement, et l'expérience le vérifie, on peut admettre que les corps volumineux ont besoin de plus d'énergie pour être convenablement excités que les petits corps. Dans le domaine médical l'excitation applicable à un gros patient doit être bien plus forte que l'excitation applicable à un petit patient, par exemple un enfant. Aussi, avant de commencer toutes les opérations correspondant à l'élaboration des images recherchées, est-il nécessaire de procéder à une opération de calibration de l'excitation. Classiquement il est connu de soumettre le corps sous examen à une série d'impulsions d'excitation radiofréquence dont l'amplitude varie d'une impulsion à l'autre. On relève, on mesure, alors le signal de précession libre (FID) après chaque impulsion, et on peut déterminer pour quelle valeur de l'excitation ce signal est passé par un maximum. Cette valeur d'excitation correspond à l'excitation à 90° recherchée. Ce procédé présente cependant de nombreux inconvénients.

En particulier, si l'acquisition d'un signal de précession libre est particulièrement simple, elle comporte néanmoins des inconvénients. D'une part ce signal est très rapidement evanescent et de plus ne rend pas compte au moment de sa mesure de la vraie valeur du signal émis par les particules, du fait des inhomogénéités du champ orientateur. Il en résulte un décalage entre la valeur vraie et la valeur ainsi déduite de l'excitation à 90°. D'autre part ce décalage rend aussi compte de l'homogénéité de l'excitation elle même. Enfin la calibration ainsi évoquée amène à la détermination des impulsions à 90°. Or l'evanescence rapide dans le temps du signal de précession libre impose que ce signal doit être mesuré, pour les expérimentatons conduisant à l'élaboration des images, avec une technique dite avec écho de spin. Selon cette technique l'excitation comporte une impulsion d'excitation à 180° qui suit dans le temps l'impulsion d'excitation à 90°. Or quel que soit le soin apporté à la réalisation des amplificateurs, multipliant par deux, qui transforment une impulsion à 90° en une impulsion à 180°, le spectre fréquentiel de ces impulsions ne peut être facilement ajusté. En effet il est connu que le spectre de fréquence de l'impulsion à 180° doit être plus large que celui de l'impulsion à 90°. L'impulsion à 180° est donc plus courte en durée que l'impulsion à 90° (en plus du fait que son amplitude est double). La correspondance entre ces différents spectres est complexe et rend impossible le calcul rapide du doublement de l'énergie d'excitation.

Pour remédier à cette difficulté, une demande de brevet EP-A 0 238 139, constituant un état de la technique au sens de l'article 54(3) de la CBE, préconise de calibrer l'excitation à 180°C connaissant par ailleurs l'excitation à 90°C. Cette procédure peut être longue et nécessite déjà de connaître l'impulsion à 90°C.

L'expérience montre en outre que l'influence de la composition spectrale de l'impulsion à 180° est prédominante dans la qualité des images élaborées avec de telles impulsions. Notamment un défaut de calibration d'une première impulsion à 180° se traduit par un artefact sous forme de ligne pointillée au centre de l'image. Il est connu de remédier à cet inconvénient en procédant à une double acquisition des informations concernant chaque image. En combinant deux acquisitions ce défaut peut être éliminé, mais ce resultat n'est obtenu qu'au prix d'un doublement de la durée d'acquisition de chaque image. Un défaut de calibration de cette première impulsion à 180° se traduit également et sourtout par un fort artefact, sur l'image de deuxième écho, sous la forme d'une image parasite symétrique de l'objet réel autour de l'un des axes. De la même façon en mauvais calage d'une deuxième impulsion 180° déclenche lors du 3° écho un fantôme symétrique de l'objet. Les défauts relatifs à la mauvaise calibration des impulsions à 180° peuvent, sous certaines conditions, être éliminés. On peut procéder dans ce but à une modification du codage par les gradients de champ lors de l'application de ces impulsions d'écho. En particulier toutes les impulsions à 180° d'ordre impair (1,3,...) sont appliquées en présence de gradients, dit de sélection, dont la durée est sensiblement la moitié de celle pendant laquelle sont appliquées les impulsions à 180° d'ordre pair (2,4,...). L'inconvénient de se procédé est d'augmenter la durée du gradient de sélection et donc de réduire d'autant, pendant la séquence en question, la durée de mesure du signal.

L'invention préconise de remédier aux inconvénients cités en améliorant notablement la qualité de la calibration : essentiellement en calibrant en présence d'une deuxième impulsion qui joue le rôle de l'impulsion à 180°. L'avantage attendu consiste à rendre moins critique l'utilisation des procédures d'élimination d'artefact qui sont contraignantes et compliquées. Dans l'invention la calibration comporte en particulier une excitation appliquée sous la forme de deux impulsions successives dans le temps. La première est censée basculer les moments magnétiques des particules, la seconde est chargée de provoquer la réflexion de la dispersion des moments magnétiques dûe aux inhomogénéités du champ orientateur. Dans la série des excitations de calibration, l'une ou l'autre de ces impulsions, où même les deux, peuvent varier d'une excitation à l'autre. Le signal mesuré, qui sert à la détermination de l'amplitude de calibration, est détécté au bout d'une durée, depuis la première impulsion, qui est égale au double de la durée qui sépare les deux impulsions.

Dans une réalisation préférée les deux impulsions sont identiques l'une à l'autre en forme et en amplitude, à chaque excitation. Un perfectionnement de l'invention consiste à appliquer ces impulsions en présence d'un gradient, dit de sélection, qui est propice à l'élimination des inhomogénéités spatiales des impulsions d'excitation. Enfin pour éliminer dans le signal reçu des contributions, correspondant à des bandes spectrales de transition du spectre en fréquence de l'impulsion d'excitation, il est préconisé d'éffectuer la détection en présence d'un gradient de champ identique au gradient de champ appliqué pendant la selection. On montrera que par un filtrage approprié les contributions de ces bandes de transition sont éliminées. La procédure générale élaborée dans la présente invention permet alors de résoudre avec une plus grande éfficacité la calibration de l'amplitude de l'excitation radiofréquence.

L'invention a pour objet un procédé de calibration de l'amplitu de de l'excitation radiofréquence d'un appareil d'imagerie par RMN comportant notamment des moyens pour produire un champ magnétique orientateur, procédé dans lequel on soumet un corps à examiner placé dans l'appareil à une série d'excitations radiofréquences d'amplitude variable d'une excitation à l'autre et dans lequel on mesure après chaque excitation le signal émis en retour par le corps quand cette excitation cesse, chaque excitation radiofréquence comportant comporte l'application, à des instants séparés dans le temps de deux impulsions radiofréquence successives pour affranchir la mesure du signal émis par les particules des inhomogénéités du champ orientateur, caractérisé en ce les formes et amplitudes des deux impulsions de chaque sont identiques l'une à l'autre et en ce que ces amplitudes varient de la même manière d'une excitation à l'autre de la série.

L'invention sera mieux comprise à lecture de la description qui suit et à l'examen des figures qui l'accompagnent. Celles-ci ne sont données qu'à titre indicatif et nullement limitatif de l'invention. Elles représentent :

- figure 1, un dispositif pour la mise en oeuvre du procédé selon l'invention;
- figure 2, l'allure de l'évolution du signal détecté, dans une variante particulière d'excitation selon l'invention, quand l'amplitude de l'excitation varie;
- figure 3a et 3b, des diagrammes temporels de signaux d'excitation et de signaux de gradient de champ nécessaires à la séléction des coupes examinées;
- figure 4a et 4b, des spectres de fréquence de signaux détectés selon la position de la coupe examinée dans le corps.

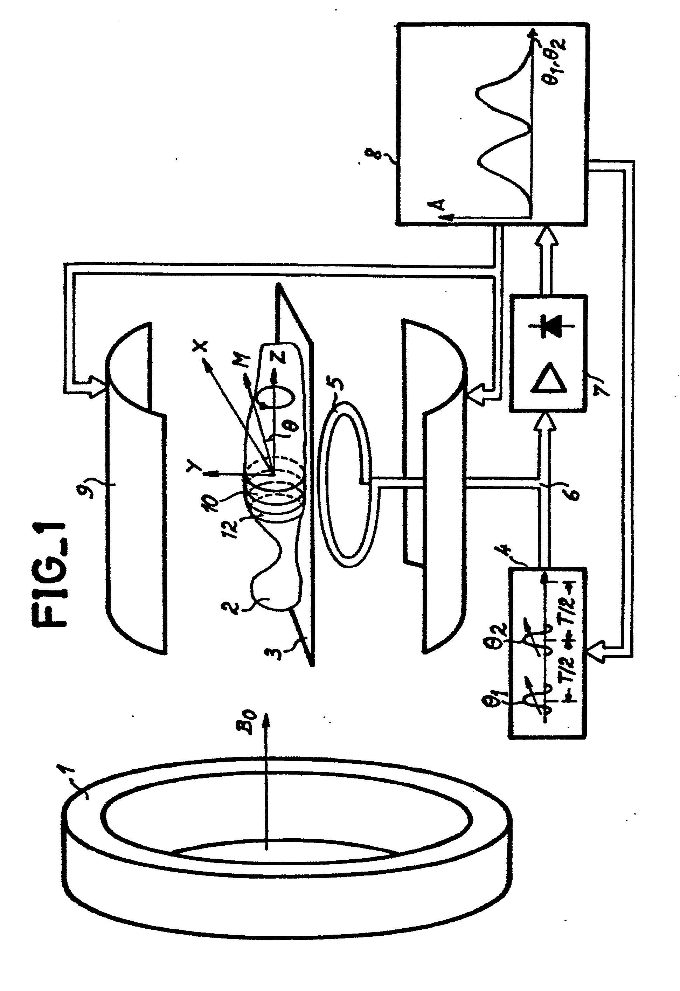

La figure 1 représente un dispositif pour la mise en oeuvre du procédé selon l'invention. Il comporte des premiers moyens 1 pour produire un champ orientateur $B_0$ dans lequel est plongé un corps 2 supporté, par exemple, par un plateau 3. Un générateur 4 applique une excitation radiofréquence au corps 2 par l'intermédiaire d'une antenne 5. Sous l'effet de cette excitation les moments magnétiques M des particules du corps 2 basculent d'un angle θ. Dès que l'excitation cesse les moments magnétiques précessent pour se réaligner avec l'orientation $B_0$ (axe Z). Ce mouvement de précession donne naissance à un signal éléctromagnétique de résonance capté par l'antenne 5. Ce signal est acheminé au moyen d'un duplexeur 6 sur un recepteur 7. Le recepteur 7 effectue aussi le traitement du signal détecté. En particulier ce signal peut être détecté puis traité quadratiquement pour en mesurer l'amplitude efficace. Cette amplitude est alors transmise à un circuit de commande 8 qui pilote tout le dispositif. Le traitement quadratique permet en plus d'éviter des inconvénients liés à l'imprécision du calage en phase d'un signal de démodulation du signal reçu.

Pendant la phase de calibration le circuit de commande 8 provoque la variation d'amplitude de l'excitation produite à chaque fois par le générateur 4. Le circuit de commande 8 peut en sus comporter un ordinateur pour relever la courbe de l'amplitude du signal détecté en fonction de l'amplitude de l'excitation appliquée. Dans l'invention l'excitation appliquée par le générateur 4 ne comporte pas qu'une impulsion mais au contraire deux impulsions $\theta_1$ et $\theta_2$, séparées l'une de l'autre d'une durée T/2. Le signal détecté est mesuré à chaque expérimentation au bout d'une période égale à T, après l'application de la première de ces deux impulsions. De préférence la durée T, ou T/2, est telle que des particules placées dans un champ $B_0$, à des limites de sa tolérance, soient déphasées l'une par rapport à l'autre au moment de la mesure (T) d'au moins 360°.

On sait qu'une impulsion a pour effet de faire basculer le moment magnétique des particules sous examen d'un angle $\theta$ dépendant de la valeur de son amplitude. Si on appelle $\theta_1$ l'angle sous lequel la première impulsion fait basculer les moments magnétiques et $\theta_2$ le même angle relatif à la deuxième impulsion, on a pu écrire que l'amplitude A du signal détecté quadratiquement par le récepteur 7 est proportionnelle à :

$$A = \sin^2(\theta_2/2) \sin \theta_1$$

Dans l'invention on propose de faire varier soit l'amplitude de la première impulsion seule ( $\theta_1$), soit l'amplitude de la deuxième impulsion seule ( $\theta_2$), soit conjointement des deux amplitudes en même temps. Quand l'amplitude de la première impulsion seule varie, $\theta_2$ est constant. On choisit pour $\theta_2$ une valeur intermédiaire (même inconnue). En conséquence le premier terme, en sinus exponent 2, de l'expression de A est constant. L'amplitude du signal détecté est alors à son maximum quand $\theta_1$ vaut 90°. A l'opposé si $\theta_1$ est constant, choisi à une valeur intermédiaire (même inconnue), l'amplitude du signal détecté est maximúm quand $\theta_2$ vaut 180°. Dans le premier cas comme dans le deuxième on ne peut pas prétendre d'avoir à faire avec un véritable phénomène d'écho de spin au moment de la reception du signal détecté calibré. En effet l'amplitude de la première impulsion ne correspond pas à un basculement de 90° quand la deuxième impulsion correspond à un basculement à 180° et vice versa. Cependant on s'aperçoit dans l'un et l'autre cas, que le signal détecté calibré n'est plus faussé pas les inhomogénéités du champ orientateur, et que sa nature evanescente n'est plus un obstacle à sa mesure.

Une autre solution consiste à faire varier conjointement, et dans le même sens, les deux impulsions de l'excitation radiofréquence. On peut les choisir avec des amplitudes respectives du simple au double. L'expérience montre cependant que ce type d'excitation n'est pas facile à mettre en oeuvre pour les raisons évoquées ci-dessus. Dans l'invention on préfère, pour discriminer avec précision les amplitudes recherchées, appliquer deux impulsions de forme et d'amplitude identiques. Et puisque la forme (le spectre) de l'impulsion à 180° est la plus importante, les deux impulsions ont un tel spectre. La valeur de l'impulsion à 90° en est ultérieurement déduite. Les imprécisions liées à la complexité de cette déduction sont içi moins critiques du fait de la nature moins critique de l'impulsion à 90°. On montre dans ces conditions, $\theta_1$ étant égal à $\theta_2$, que l'amplitude du signal détecté peut s'écrire de la manière suivante :

$$A = 2 \sin^3 \theta/2 \cos \theta/2 \text{ si } \theta_1 = \theta_2 = \theta.$$

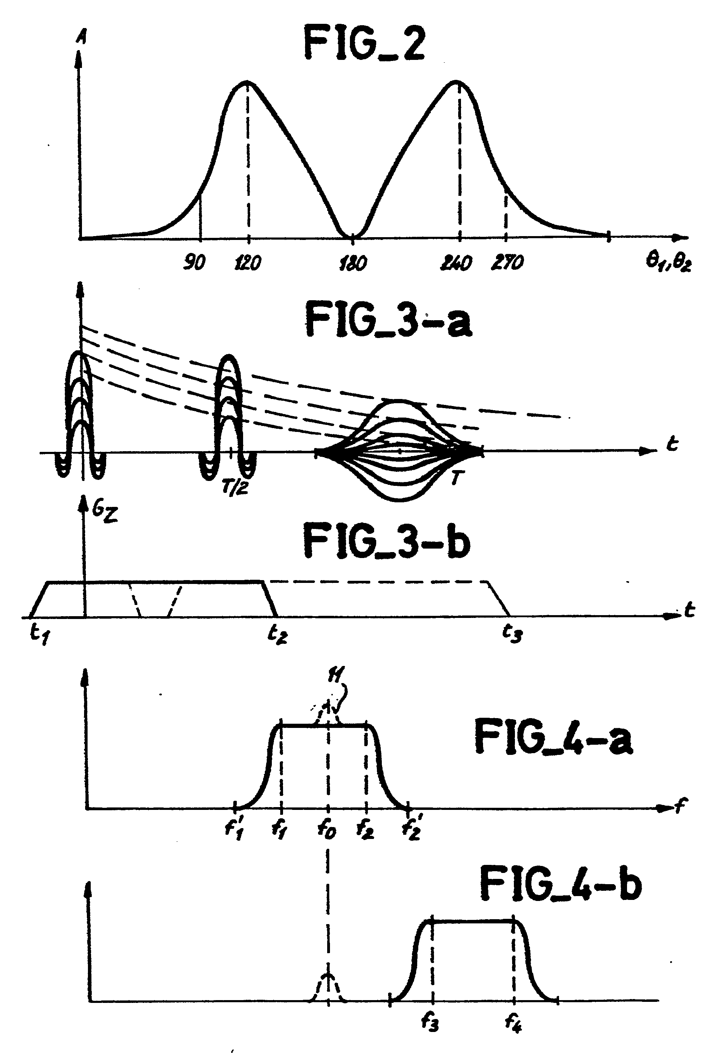

Cette expression présente alors l'avantage que A vaut 0 quand $\theta$ vaut 180°. La recherche d'une valeur par le passage à 0 d'un signal détecté est effectivement physiquement plus simple à mettre en oeuvre et plus précise dans sa détermination. Sur le plan pratique dans ce cas particulier l'allure du signal A détecté quadratiquement a une forme du type de celle représentée sur la figure 2. Il passe par un maximum quand ces impulsions correspondent, chacune, à faire basculer d'environ 120° les moments magnétiques. Il passe par un minimum quand chacune correspond à une impulsion de basculement à 180°. La figure 3a montre l'évolution des amplitudes des impulsions d'excitation à t = 0 et t = T/2 et l'évolution de l'amplitude du signal détectée autour de t = T. D'une expérience à l'autre, par exemple, les amplitudes des impulsions croissent tandis que d'une manière conjointe l'amplitude du signal détecté décroit.

Il arrive quelquefois que les patients, au cours de la phase de calibration, soient placés sans précaution particulière sur le plateau 3. Par exemple leurs membres supérieurs peuvent être très proches de l'antenne 5 au point même qu'ils la touchent avec les mains. Il en résulte une inhomogénéité provoquée de la distribution spatiale de l'excitation radiofréquence. Cette inhomogénéité retentit dans la mesure du signal de calibration et la fausse. Pour éviter les inhomogénéités de la distribution de l'excitation radiofréquence, il est proposé dans l'invention d'effectuer cette calibration sur une tranche particulière 10 du corps 2 : là où on sait qu'en tout état de cause l'homogénéité spatiale de l'excitation est acquise. Par exemple, confer figure 1, on détermine au moyen de bobines de gradient de champ 9 des conditions particulières de polarisation magnétique du corps 2 pour que le phéomène de résonance ne puisse prendre naissance, à chaque excitation, que dans une tranche fine 10 de ce corps. Les bobines de gradient 9, pilotées par le séquenceur 8 appliquent en effet dans la tranche 10 un supplément de champ magnétique et modifient dans cette région la fréquence de résonance. En adaptant le spectre de fréquence de l'excitation à cette fréquence de résonance, on sélectionne pour le phénomène de résonance, la tranche 10 dans le corps 2. La figure 3b montre le diagramme temporel d'application d'un gradient de champ $G_z$ simultanément à l'application de l'excitation (avec ses deux impulsions). En agissant ainsi on élimine les défauts de répartition spatiale de l'excitation. En variante le gradient de sélection peut être coupé entre les deux impulsions de l'excitation.

La figure 4a montre le diagramme spectral des impulsions d'excitation. Le diagramme a une bande passante f1 - f2 correspondant à la largeur géométrique de la tranche 10 dans le corps 2. En effet dans la pratique le supplément de champ orientateur apporté par les gradients ne peut pas être appliqué brutalement à certains endroits et pas du tout à d'autres. Il est appliqué progressivement et linéairement en fonction de l'abcisse de la tranche, mesurée selon un axe (ici l'axe Z). En conséquence du début de la tranche 10 à la fin de la tranche 10, les conditions de résonance ne sont pas les mêmes en fréquence. Ceci justifie la largeur de la bande passante des impulsions d'excitation. Cependant la définition précise d'une tranche n'est pas possible du fait que la bande passante du spectre des impulsions d'excitation est toujours bordée par des bandes de transition $f'_1$ - $f_1$ et $f_2$ - $f'_2$. Les parties latérales de la tranche recevant des excitations avec des amplitudes affaiblies correspondant à ces bandes de transition ne sont donc pas excitées correctement : elles ne basculent pas de 180° deux fois de suite au moment où $\theta_1 = \theta_2 = 180°$. En conséquence, les particules situées dans les bords de la tranche produisent alors un signal qui perturbe l'existence du minimum de la figure 2. La précision de la détermination de ce minimum s'en trouve amoindrie.

Dans l'invention on préconise alors de recevoir le signal de retour à l'équilibre des particules en présence d'un gradient effectuant une partition en fréquence selon le même axe (Z) que celui utilisé pour la selection de la tranche 10. Dans ces conditions dans le signal reçu les différentes parties de la tranche 10, y compris les bords, participent au signal par des composantes fréquentielles différentes. On rappelle qu'en absence de ce gradient de "lecture" tout les moments magnétiques de la tranche precessent à une fréquence unique, dépendant seulement du champ orientateur $B_0$. Sur le plan pratique il est plus simple, plutôt que de choisir une autre valeur pour ce gradient appliqué pendant la lecture, de maintenir le gradient de selection jusqu'à la fin de cette lecture. En conséquence le gradient de sélection, appliqué de $t_1$ à $t_2$ pour éliminer les inhomogénéités de la distribution spatiale de l'excitation, est maintenant maintenu jusqu'à une date $t_3$ ultérieure à la fin de la lecture de manière à moduler en fréquence le signal mesuré (figure 3b). Il suffit ensuite de filtrer le signal mesuré avec un filtre dont la bande passante est inférieure, et est comprise, dans l'intervalle $f_1$ - $f_2$ pour éliminer du signal reçu les composantes représentatives du basculement non calibré des bords de la tranche 10.

Dans la pratique il est connu, en particulier avec des procédés d'imagerie multicoupes d'exciter des tranches 10, adjacentes les unes aux autres dans le corps 2, en appliquant un même gradient de sélection mais en décalant la bande passante d'excitation. Ce décalage de fréquence d'excitation est généralement obtenu en utilisant un oscillateur à fréquence fixe $f_0$ qui module un signal dont le spectre est compris entre $f_1$ - $f_0$ et $f_2$ - $f_0$. Malheureusement avec cette technique le spectre du signal d'excitation n'est pas rigoureusement plat dans la bande utile $f_1$ - $f_2$. En effet il comporte un pic d'amplitude 11 à $f_0$ dont il difficile de se défaire (figure 4a). Aussi, dans l'invention, on perfectionne la calibration en évitant ce défaut. Dans ce but on décale la tranche examinée. Ceci revient à décaler la fréquence de l'excitation de telle manière que, du fait de la présence du gradient de champ suplémentaire, la fréquence de résonance qu'elle fait naitre se situe dans une bande $f_3$ - $f_4$ extérieure à la bande $f_1$ - $f_2$. Dans ces conditions le filtrage du signal reçu dans cette bande $f_3$ - $f_4$ ne comporte pas de composante représentative de moments magnétiques qui auraient tourné, au moment de la calibration, de plus de 180° du fait de la présence de la suroscillation 11 dans le spectre $f_1$ - $f_2$.

## Revendications

1. Procédé de calibration de l'amplitude de l'excitation radiofréquence d'un appareil d'imagerie par RMN comportant notamment des moyens pour produire un champ magnétique orientateur, procédé dans lequel on soumet un corps (2) à examiner placé (3) dans l'appareil à une série d'excitations radiofréquences d'amplitude variable d'une excitation à l'autre et dans lequel on mesure (7) après chaque excitation le signal émis en retour par le corps quand cette excitation cesse, caractérisé en que chaque excitation radiofréquence comporte l'application, à des instants séparés dans le temps, de deux impulsions radiofréquence successives ($\theta_1$, $\theta_2$) pour affranchir la mesure du signal émis par les particules des inhomogénéités du champ orientateur($B_0$) caractérisé en ce que les formes et amplitudes des deux impulsions de chaque excitation sont indentiques l'une à l'autre et en ce que ces amplitudes varient de la même manière d'une excitation à l'autre de la série..

2. Procédé selon la revendication 1 caractérisé en ce l'excitation est appliquée en présence d'un champ orientateur supplémentaire (Gz), dit gradient de champ, dont la valeur dépend d'une abscisse mesurée selon un axe orienté dans une direction donnée (Z) par rapport au corps pour effectuer une selection de coupe (10) lors de l'excitation et diminiuer ainsi les défauts d'homogénéité spatiale de l'excitation radiofréquence.

3. Procédé selon la revendication 2 caractérisé en ce que la mesure du signal émis par les particules est effectuée en présence ($t_3$) du champ orientateur supplémentaire présent pendant l'excitation et en ce qu'on filtre en fréquence ($f_1$ - $f_2$) le signal émis par les particules pour éliminer des contributions dépendant des bandes latérales du spectre de l'excitation.

4. Procédé selon la revendication 3 caractérisé en ce que le gradient de champ a une forme antisymétrique par rapport à une abscisse donnée dans le corps et en ce que la fréquence de l'excitation, égale à la fréquence centrale du filtre, est décalée ($f_3 - f_4$) par rapport à une fréquence ($f_0$) de résonance magnétique nucléaire correspondant au lieu du corps où ce gradient de champ suplémentaire est nul.

5. Procédé selon la revendication 3 ou selon la revendication 5, caractérisé en ce que le champ suplémentaire est maintenu ($t_1 - t_3$) du début de l'excitation à la fin de la mesure.

6. Procédé selon la revendication 1, caractérisé en ce que la forme des impulsions correspond à la forme d'une impulsion à 180°.

7. Procédé selon l'une quelconque des revendications 1 à 7 caractérisé en ce que la durée (T/2) qui sépare les deux impulsions est suffisante pour que les inhomogénéités du champ orientateur fourni par l'appareil induisent un déphasage au moins égal à 360° entre les signaux émis par des particules se trouvant en des endroits où le champ est à des limites de sa tolérance.

8. Procédé selon l'une quelconque des revendications 1 à 8 caractérisé en ce que la mesure du signal émis comporte un traitement quadratique de ce signal pour éliminer les imprécisions du calage en phase d'un signal de démodulation.

## Patentansprüche

1. Verfahren zur Kalibrierung der Amplitude der Funkfrequenz-Erregung eines RMN-Abbildungsgerätes, das insbesondere Mittel umfaßt, um ein Orientierungs-Magnetfeld zu erzeugen, wobei in diesem Verfahren ein in dem Gerät angeordneter (3), zu untersuchender Körper (2) einer Reihe von Funkfrequenz-Erregungen einer Amplitude ausgesetzt wird, die von einer Erregung zur nächsten veränderbar ist und in welchem nach jeder Erregung das von dem Körper zurückgegebene Signal nach Beendigung dieser Erregung gemessen wird (7), wobei jede Funkfrequenz-Erregung die Anwendung zweier aufeinanderfolgender Funkfrequenzimpulse ($\theta_1$, $\theta_2$) zu zeitlich getrennten Zeitpunkten umfaßt, um die Messung des durch die Partikeln abgegebenen Signals von den Inhomogenitäten des Orientierungs-Feldes ($B_0$) zu befreien, dadurch gekennzeichnet, daß die Forme sowie die Amplitude der beiden Impulse jeder Erregung jeweils einander gleich sind und daß diese Amplituden von einer Erregung zur nächsten in der Reihe auf gleiche Weise variieren.

2. Verfahren nach Anspruch 1, dadurch gekennzeichnet, daß die Erregung bei Vorhandensein eines zusätzlichen, als Feldgradient bezeichneten Orientierungs-Feldes ($G_Z$) ausgeübt wird, dessen Wert von einer Abszisse abhängt, die entlang einer Achse gemessen wird, welche in einer beistimmten Richtung (Z) in bezug auf den Körper orientiert ist, um während der Erregung eine Schnittauswahl (10) auszuführen und so die Fehler der räumlichen Homogenität der Funkfrequenz-Erregung zu verringern.

3. Verfahren nach Anspruch 2, dadurch gekennzeichnet, daß die Messung des durch die Partikeln abgegebenen Signals bei Vorhandensein ($t_3$) des zusätzlichen Orientierungs-Feldes, das während der Erregung vorhanden ist, erfolgt und daß das durch die Partikeln abgegebene Signal einer Frequenzfilterung ($f_1–f_2$) unterzogen wird, um Anteile, die von Seitenbändern des Spektrums der Erregung abhängig sind, zu beseitigen.

4. Verfahren nach Anspruch 3, dadurch gekennzeichnet, daß der Feldgradient in bezug auf eine in dem Körper gegebene Abszisse eine antisymmetrische Form aufweist und daß die Frequenz der Erregung, die der Zentralfrequenz des Filters entspricht, in bezug auf eine Frequenz ($f_O$) einer magnetischen Kernresonanz verschoben ist ($f_3–f_4$), die der Stelle des Körpers, in welchem dieser zusätzliche Feldgradient gleich Null ist, entspricht.

5. Verfahren nach Anspruch 3 oder 4, dadurch gekennzeichnet, daß das zusätzliche Feld von Anfang der Erregung an bis zur Beendigung der Messung beibehalten ($t_1–t_3$) wird.

6. Verfahren nach Anspruch 1, dadurch gekennzeichnet, daß die Form der Impulse der Form eines Impulses bei 180° entspricht.

7. Verfahren nach einem der Ansprüche 1 bis 6, dadurch gekennzeichnet, daß die die beiden Impulse trennende Dauer (T/2) ausreicht, damit die Inhomogenitäten des durch das Gerät gelieferten Orientierungs-Feldes eine Phasenverschiebung von mindestens 360° zwischen den durch solche Partikeln abgegebenen Signalen erzeugen, welche sich an Stellen befinden, an denen das Feld seine Toleranzgrenzen aufweist.

8. Verfahren nach einem der Ansprüche 1 bis 7, dadurch gekennzeichnet, daß die Messung des abgegebenen Signals eine quadratische Behandlung dieses Signals umfaßt, um die Ungenauigkeiten der Phasenfestlegung eines Demodulations-Signals zu beseitigen.

## Claims

1. A method of calibrating the amplitude of radiofrequency excitation of an NMR image producing device more especially comprising means in order to produce an orientating magnetic field, in which method a body (2) to be examined placed (3) in the device is subjected to a series of radio frequency excitations with an amplitude varying from one excitation to the next one and in which after each excitation the signal emitted in return by the body is measured (7) when such excitation ceases, each radiofrequency excitation comprising the application, at separate points in time, of two successive radiofrequency pulses ($\theta_1$ and $\theta_2$) in order to free the measurement of the signal emitted by the particles of inhomogeneities of the orientating field ($B_0$), characterized in that the shapes and the amplitudes of the two pulses of each excitation are identical to each other and in that such amplitudes vary in the same manner from one excitation to another in the series.

2. The method as claimed in claim 1, characterized in that the excitation is applied in the presence of a supplementary orientating field ($G_Z$) as a field gradient, whose value depends on an abscissa value measured along an axis orientated in a given direction (Z) in relation to the body in order to perform a selection of the cut (10) at the time of the excitation and thus to diminish the lack of spatial homogeneity of the radiofrequency excitation.

3. The method as claimed in claim 2, characterized in that the measurement of the signal emitted by the particles is performed in the presence ($t_3$) of the supplementary orientating field present during the excitation and in that the signal emitted by the particles is filtered for the frequency ($f_1$ to $f_2$) in order to eliminate the effects due to the lateral bands of the excitation spectrum.

4. The method as claimed in claim 3, characterized in that the field gradient has an antisymmetrical form in relation to a given abscissa value present in the body and in that the excitation frequency, equal to the center frequency of the filter, is offset ($f_3-f_4$) in relation to nuclear magnetic resonance frequency ($f_0$) corresponding to the position of this body where the field gradient is zero.

5. The method as claimed in claim 3, characterized in that the supplementary field is maintained ($t_1$ through $t_5$) from the start of excitation to the end of the measuring operation.

6. The method as claimed in claim 1, characterized in that the form of the pulses corresponds to the form of an 180° pulse.

7. The method as claimed in any one of the preceding claims 1 through 6, characterized in that the duration (T/2) between the two pulses is sufficient to ensure that the inhomogeneities in the orientating field supplied by the device cause a phase offset equal to at least 360° between the signals emitted by the particles located at positions where the field is at its limits of tolerance.

8. The method as claimed in any one of the preceding claims 1 through 7, characterized in that the measurement of the signal emitted comprises a squaring operation on the signal in order to eliminate the lack of precision due to phase offset of a signal after demodulation.

FIG_1

EP 0 245 154 B1

EP 0 245 154 B1

FIG_2

FIG_3-a

FIG_3-b

FIG_4-a

FIG_4-b